Europäisches Patentamt

European Patent Office

Office européen des brevets

(11) Publication number: **0 207 699**
A2

# EUROPEAN PATENT APPLICATION

(21) Application number: 86304772.6

(22) Date of filing: 20.06.86

(51) Int. Cl.4: **H01L 33/00** , H01S 3/101 , H01S 3/19

(30) Priority: 28.06.85 JP 140384/85
18.04.86 JP 87908/86

(43) Date of publication of application:
07.01.87 Bulletin 87/02

(84) Designated Contracting States:
DE FR GB

(71) Applicant: **HITACHI, LTD.**
**6, Kanda Surugadai 4-chome Chiyoda-ku**
**Tokyo 100(JP)**

(72) Inventor: **Mishima, Tomoyoshi**
**1-12-10, Kamimuneoka**
**Shiki-shi Saitama-ken(JP)**
Inventor: **Kasai, Junichi**
**Wakana Apt. 2-22-8, Akatsutsumi**
**Setagaya-ku Tokyo(JP)**
Inventor: **Morioka, Makoto**
**2196-64, Hirai Hinode-machi**
**Nishitama-gun Tokyo(JP)**
Inventor: **Shiraki, Yasuhiro**
**1-106, 3-26-1, Hirayama**
**Hino-shi Tokyo(JP)**
Inventor: **Katayama, Yoshifumi**
**1303-9, Shimotomi**
**Tokorozawa-shi Saitama-ken(JP)**
Inventor: **Sawada, Yasushi**
**3-1-3, Higashi-Koigakubo**
**Kokubunji-shi Tokyo(JP)**
Inventor: **Murayama, Yoshimasa**
**4-2-1-320, Maehara-cho**
**Koganei-shi Tokyo(JP)**

(74) Representative: **Stuart, Ian Alexander et al**
**MEWBURN ELLIS & CO. 2/3 Cursitor Street**
**London EC4A 1BQ(GB)**

(54) Light-emitting element having multiquantum-well structure.

(57) A semiconductor laser or a light-emitting diode having multiquantum-well structure constituted by compound semiconductor layers, wherein the quantum well width which constitutes the quantum well or the energy difference between a barrier layer and a quantum well layer, is so selected that the highest level among the quantum levels in the quantum well is not brought into agreement with the energy level of the barrier layer, so that carrier injection is promoted into the quantum well. Therefore, there is obtained a semiconductor laser device having a very small threshold current and a high differential quantum efficiency.

## LIGHT-EMITTING ELEMENT HAVING MULTIQUANTUM-WELL STRUCTURE

The present invention relates to a light-emitting element, and particularly to a light-emitting element such as a light-emitting diode or a semiconductor laser having a multiquantum-well structure in the light-emitting region.

Conventional semiconductor lasers and light-emitting diodes (hereinafter referred to as LED's) have been realized with a structure consisting of a pn junction of the same material or with a single-heterostructure or a double-heterostructure in which one side of the pn junction or both sides of the light-emitting region (active region) are constituted by a material having a high energy bandgap. In order to increase the efficiency of radiative recombination in the light-emitting region of the semiconductor laser or the LED, there has recently been proposed a multiquantum-well structure in which quantum well layers (or active layers) composed of a material having a lower energy bandgap are sandwiched by barrier layers (or confinement layers) composed of a material having a higher energy bandgap in the light-emitting region, as disclosed in "Electronics Letters", Vol. 19, No. 6, March 17, 1983.

Objects that may be achievable by preferred embodiments of the invention include the following:

to provide a light-emitting element, particularly a semiconductor laser, a light-emitting diode, or the like, having a high light generation efficiency;

to provide a semiconductor laser or a light-emitting diode having a high light generation efficiency and a low threshold current, and to realize a light source that can be adapted to lightwave communications, optical discs and facsimiles.

The present invention deals with a semiconductor light emitting device, e.g. a laser

or a light-emitting diode, having a multiquantum-well structure constituted by compound semiconductor layers, wherein the quantum well width which constitutes the quantum well or the energy difference (barrier height) between a barrier layer and a quantum well layer, is so selected that the highest level among the quantum levels in the quantum well is not brought into agreement with the energy level (uppermost end of the valence band or lowermost end of the conduction band) of the barrier layer. Therefore carrier injection into the quantum well may be promoted, and there may be obtained a semiconductor laser having a very small threshold current and a high differential quantum efficiency.

Brief Description of the Drawings

Fig. 1 is a diagram showing the dependency of the threshold current density upon the quantum well width of a quantum well laser device (barrier layer: $Al_xGa_{1-x}As$);

Fig. 2 is a section view of a semiconductor laser device embodying the present invention, wherein Fig. 2(a) is a diagram showing the whole device, and Fig. 2(b) is a diagram showing a portion of the device on an enlarged scale;

Fig. 3 is a diagram showing relationships between the excitation intensity and the luminescence intensity in the PL;

Fig. 4 is a diagram showing relationships between the quantum well width and the index of dependency of luminescence intensity for the quantum well width and the excitation intensity; and

Fig. 5 is a perspective view showing the structure of a multiquantum-well LED.

Detailed Description of Embodiments of the Invention

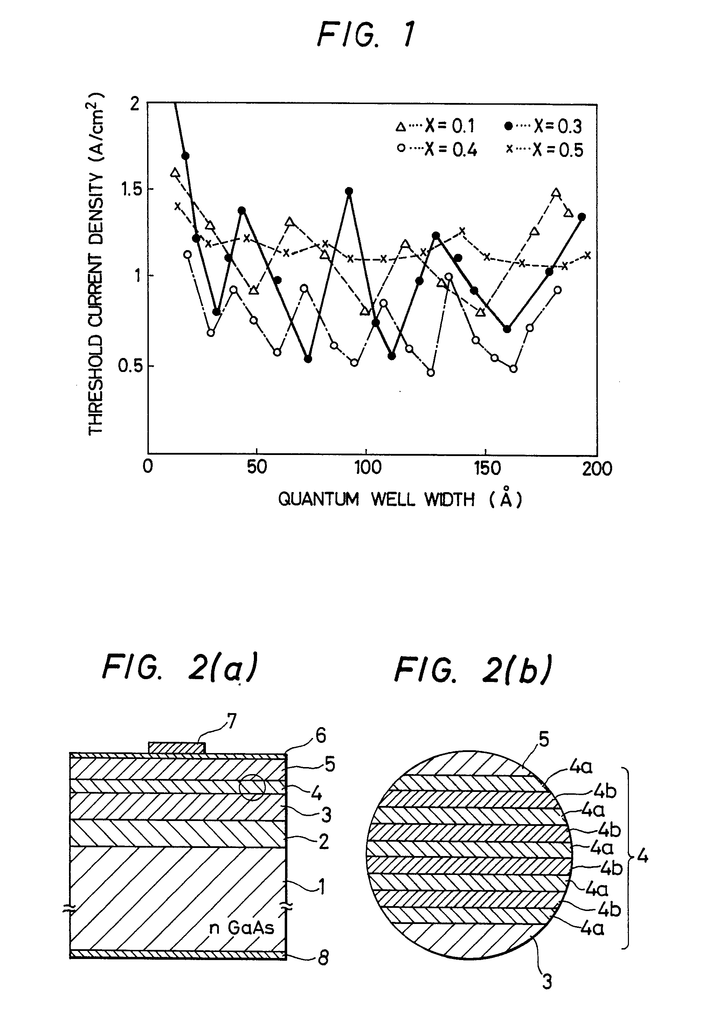

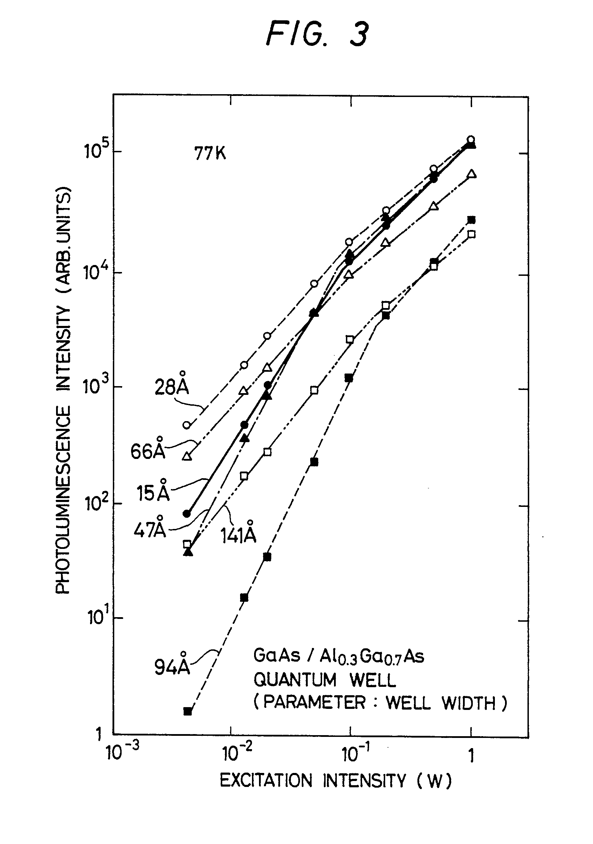

No close study has yet been made concerning the effect of the quantum well width upon the light generation efficiency in a semiconductor laser device which has multiquantum-well structure, except a report concerning a GRIN-SCH semiconductor laser (preparatory document for the lecture on applied physics, spring 1985) by Yagi et al.). The present inventors have made experiments and a thorough study, and have found the fact that when a laser active region is constituted in which thin GaAs active layers are respectively sandwitched by GaAlAs confinements regions in an $Al_xGa_{1-x}As/GaAs$ semiconductor laser device, the threshold current decreases singularly when the quantum well width is near 50, 98 or 148 angstroms with x = 0.1, when the quantum well width is near 43, 87, 131, or 175 angstroms (not shown to simplify the drawing) with x = 0.2, when the quantum well width is near 32, 74, 110, or 160 angstroms with x = 0.3, and when the quantum well width is near 30, 61, 93, 125 or 159 angstroms with x = 0.4, as shown in Fig. 1. The above effect stems from the fact that the energy levels of electrons and holes formed in the quantum well change with the change in the quantum well width, and are deviated from the barrier height, causing the carrier injection into the quantum well to be promoted. Therefore, if a quantum well laser is fabricated by selecting the quantum well width that exhibits the above low

2

threshold current, there can be realized a semiconductor laser device that exhibits a high quantum efficiency with a small threshold current, that could not be implied thus far.

That is, by forming the quantum well having a particular width, there can be obtained a semiconductor laser device which permits a very small threshold current to flow and which exhibits a high differential quantum efficiency.

The inventors have examined threshold currents by varying the width of quantum well over a region of 10 to 200 angstroms as described above, and have found the fact that the threshold current decreases singularly at the above-mentioned quantum well widths with x-values of x = 0.1, 0.3 and 0.4 (threshold currents of when x = 0.2 are not shown, to simplify the drawing as shown in Fig. 1) When x = 0.5 which establishes an indirect transition semiconductor region, the threshold current decreases periodically in the same manner as mentioned above. The threshold current, however, decreases in amounts smaller than those of the direct transition region of up to about x = 0.4. Relying upon the above-mentioned phenomenon, the present invention deals with a semiconductor laser device having multiquantum-well structure which employs a compound semiconductor, wherein the quantum well width which constitutes the quantum well or the energy difference (barrier height) between a barrier layer and a quantum well layer, is so selected that the highest level among the quantum levels in the quantum well is not brought into agreement with the energy level of the barrier layer, so that the carrier injection into the quantum well is promoted, the threshold current is greatly reduced, and that the differential quantum efficiency increases.

The present invention further provides an LED which employs the multiquantum well structure in the light-emitting region, the LED having a quantum well width of an optimum light generation efficiency.

Fig. 3 shows the dependency of photoluminescence (PL) intensity $I_{PL}$ upon the excitation intensity $I_{EX}$ when the width of the $Al_{0.3}Ga_{0.7}As$ barrier layer (or confinement layer) is maintained constant and when the width of the GaAs quantum well layer (or active layer) is changed in a $GaAs/Al_{0.3}Ga_{0.7}As$ multiquantum well. Fig. 4 shows the dependency of PL upon the exciting light intensity ($I_{PL} \propto I_{EX}^{m}$), i.e., shows the dependency of index (proportional constant of the logarithmic notation) upon the quantum well width. It will be understood that the oscillation takes place between m = 1 and m = 2 due to the quantum well width relative to the exciting light intensity, i.e., relative to the injected carrier density of the LED. To fabricate a multiquantum-well LED having better light generation efficiency, the quantum well width must be so formed that m = 1. In physical image, when m = 2, the highest energy level (in the conduction band) among the energy levels discretely formed in the quantum well is in agreement with the bottom of conduction band of the barrier layer. When m = 1, the position of the highest energy level in the quantum well is sufficiently deeper than the bottom of conduction band of the barrier layer.

The invention will now be described in detail by way of embodiments.

Embodiment 1:

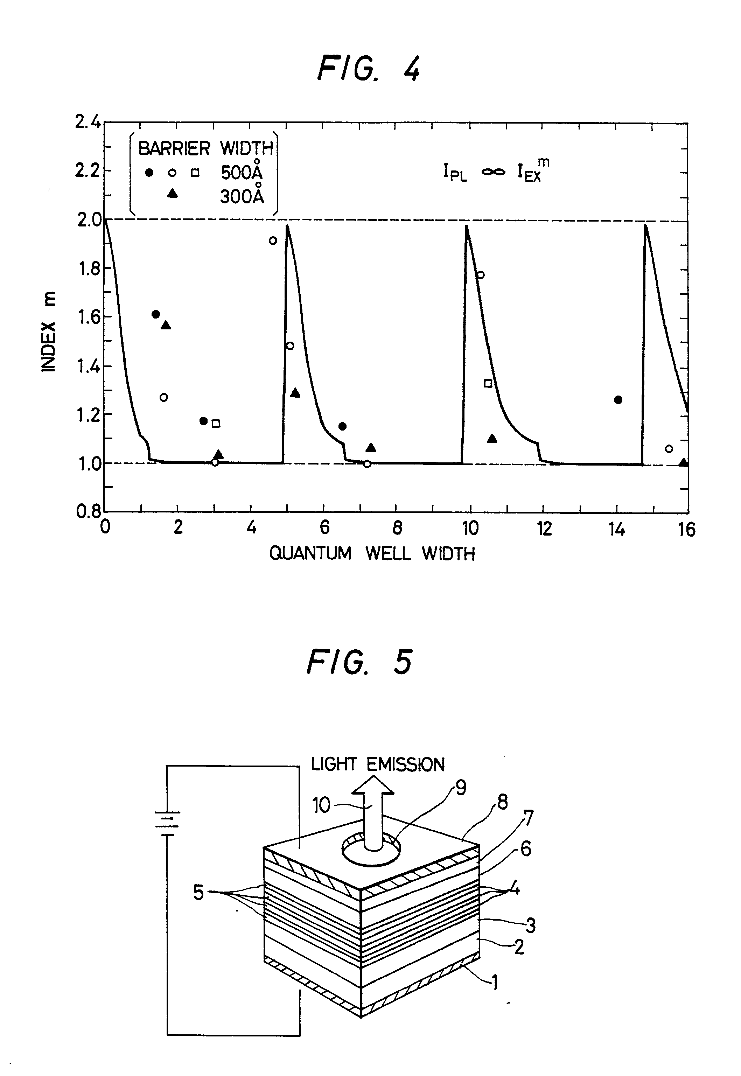

Fig. 2 is a section view which illustrates a semiconductor laser device according to an embodiment of the present invention, wherein Fig. 2-(a) is a diagram showing the whole device, and Fig. 2(b) is a diagram showing an encircled portion thereof on an enlarged scale. As shown in Figs. 2-(a) and 2(b), on a (100)n⁺-GaAs substrate (doped with silicon at a concentration of about $2 \times 10^{18}$ $cm^{-3}$) 1 are grown as n⁺-GaAs buffer layer (0.5 $\mu$m) thick, n-type impurity concentration of $2 \times 10^{18}$ $cm^{-3}$) 2, an $n-Al_{0.5}Ga_{0.5}As$ cladding layer (0.5 $\mu$m thick, n-type impurity concentration of $1 \times 10^{18}$ $cm^{-3}$) 3, an undoped multiquantum-well layer - [consisting of five $Al_{0.3}Ga_{0.7}$ As layers (each 100 angstroms thick) 4a and four GaAs layers (each 74 angstroms thick) 4b that are alternatingly lamintated] 4, a $p-Al_{0.5}Ga_{0.5}As$ cladding layer (1 $\mu$m thick, p-type impurity concentration of $5 \times 10^{18}$ $cm^{-3}$, doped with beryllium) 5, and a p⁺-GaAs layer (0.2 $\mu$m thick, p-type impurity concentration of $8 \times 10^{18}$ $cm^{-3}$, doped with beryllium) 6 by the molecular beam epitaxy (MBE) system maintaining the substrate temperature at 580°C. The GaAs is grown at a rate of 1 $\mu$m per hour. On the thus obtained wafer are further formed a striped AuAgZn electrode 7 having a size of 5 $\mu$m x 300 $\mu$m and an AuGeNi electrode 8 on the back surface thereof by vacuum evaporation. There is fabricated a semiconductor laser device of the gain induced stripe type having a quantum well width of 74 angstroms as described above. The thus fabricated semiconductor laser device exhibits a threshold current density of as small as 650 A/cm².

When the GaAs quantum well width is selected to be 50 angstroms or 90 angstroms (that is, deviated from optimum values of 32 ± 5, 74 ± 10, 110 ± 10, and 160 ± 10 angstroms), the threshold current density increases to larger than 900 A/cm². Further, the semiconductor laser device having the quantum well width of 72 angstroms of this embodiment exhibits a differential quantum efficiency which is increased by about 10% compared with other semiconductor laser devices having quantum well widths of 50 angstroms and 90 angstroms. According to this embodiment as described above, the threshold current can be decreased and the differential quantum efficiency can be increased. If an optimum quantum well width is selected as described above, substantially the same effects can be exhibited even with the laser device of any other stripe structure such as graded index type laser, buried heterostructure laser, and the like lasers.

Though the above embodiment has employed materials of the AlGaAs/GaAs type, the same effects can also be obtained by selecting such a quantum well width that increases the carrier injection into the quantum well layer even when materials of other compound semiconductor types are used such as $Al_xGa_{1-x}As/Al_yGa_{1-y}As$; $In_x Ga_{1-x}AsP_{1-y}/InP$, $In_xGa_{1-x}As/In_yAl_{1-y}As$; and $In_x Ga_{1-x}P/In_yAl_{1-y}P$.

According to the semiconductor laser device having, as an active region, multiquantum-well structure which employs compound semiconductors of the present invention as described above, the quantum well width which constitutes the quantum well or the energy difference between a barrier layer and a quantum well layer, is so selected that the highest level among the quantum levels in the quantum well is not brought into agreement with the energy level of the barrier, so that the energy level of electrons and holes formed in the quantum well helps promote the carrier injection into the quantum well regardless of the barrier height. Therefore, there can be fabricated a quantum well type semiconductor laser which permits a greatly reduced threshold current to flow and which exhibits a quantum efficiency that is increased by about 10%.

Embodiment 2:

Fig. 5 illustrates the structure of an LED according to the present invention, wherein reference numeral 11 denotes an ohmic contact electrode of the n-type side, 12 denotes an n+-type GaAs substrate, and 13 denotes an n+-type $Al_{0.3}Ga_{0.7}As$ layer. A light-emitting region of multiquantum well is constituted by undoped GaAs layers 14 and undoped $Al_{0.3}Ga_{0.7}As$ layers 15. Each GaAs layer has a thickness of 75 angstroms and each $Al_{0.3}Ga_{0.7}As$ barrier layer has a thickness of 300 angstroms so that a value of m will be about 1 as shown in Fig. 4. The LED of this embodiement uses four GaAs layers and five $Al_{0.3}Ga_{0.7}As$ layers. Reference numeral 16 denotes a p+-type $Al_{0.3}Ga_{0.7}As$ layer, 17 denotes a p+-type GaAs layer for ohmic contact, and 18 denotes an ohmic-contact electrode of the p-type side. The LED structure according to this embodiment is fabricated by the molecular beam epitaxy (MBE). According to this LED, the positive side of the power source is connected to the contact electrode of the p-type side, and the negative side of the power source is connected to the contact electrode of the n-type side, so that light 20 is emitted from the multiquantum-well region through a light-emitting window 19. The p+-type GaAs layer for ohmic contact under the window 19 has been removed by etching, so that the light that is emitted is not interrupted.

The LED produces an optical output of 1.5 mW when the drive current is 50 mA. The output of 1.5 mW is about 1.5 times as great as that of the LED of the same structure but which does not have an optimum well width.

According to the present invention, a multiquantum-well type LED can be fabricated having a quantum well width which produces the greatest light generation efficiency, the LED being driven on a small current.

## Claims

1. A semiconductor light-emitting element comprising an active region with a multiquantum-well structure which employs compound semiconductors, wherein the quantum well width which constitutes the quantum well or the energy difference between a barrier layer and a quantum well layer, is so selected that the highest level among the quantum levels in the quantum well is not brought into agreement with the energy level of the barrier layer.

2. A light-emitting element according to claim 1, wherein said barrier layer consists of a direct transition-type semiconductor.

3. A light-emitting element according to claim 1 or 2, wherein said quantum well width has a value of 50 ± 10, 98 ± 10, or 148 ±10 angstroms when x = 0.1 ± 0.05, has a value of 43 ± 10, 87 ± 10, 131 ± 10, or 175 ± 10 angstroms when x = 0.2 ± 0.05, has a value of 32 ± 5, 74 ± 10, 110 ± 10 or 160 ± 10 angstroms when x = 0.3 ± 0.05, or has a value of 30 ± 5, 61 ± 10, 93 ±10, 125 ± 10, or 159 ± 10 angstroms when x = 0.4 ± 0.05.

4. A light-emitting element having multiquantum-well structure, wherein the quantum well width is so selected that the position of the highest energy level among the levels discretely formed in the quantum well is not in agreement with the bottom of the conduction band of a barrier layer.

5. A light-emitting element having multiquantum-well structure according to any preceding claim, wherein the quantum well width is so selected that the highest energy level among the levels discretely formed in the quantum well is close to the bottom of the conduction band of the quantum well.

6. A light-emitting element according to any preceding claim, wherein said light-emitting element is a semiconductor laser or a light-emitting diode.

7. A light-emitting element according to any preceding claim wherein the multiquantum-well structure is provided by layers comprising one or more of: $Al_xGa_{1-x}As/GaAs$; $Al_xGa_{1-x}As/Al_yGa_{1-y}As$; $In_xGa_{1-x}AsP_{1-y}/InP$, $In_xGa_{1-x}As/In_yAl_{1-y}As$; and $In_xGa_{1-x}P/In_yAl_{1-y}P$.

8. A light-emitting element according to claim 7 wherein the multiquantum-well structure is provided by layers of AlGaAs/GaAs type.

9. A light-emitting element according to any preceding claim which is a semiconductor laser device of the gain induced stripe type, graded index type laser or buried heterostructure laser.

10. A light-emitting element according to any preceding claim wherein the multiquantum-well structure is provided by layers which are undoped.

## FIG. 1

## FIG. 2(a)

## FIG. 2(b)

## FIG. 3

GaAs / $Al_{0.3}Ga_{0.7}As$
QUANTUM WELL
(PARAMETER : WELL WIDTH)

0 207 699

FIG. 4

FIG. 5

LIGHT EMISSION